# DEMANDE DE BREVET EUROPEEN

(11) **EP 1 416 620 A1**
(43) Date de publication de la demande: **06.05.2004**
(21) Numéro de dépôt: 03300167.8
(22) Date de dépôt: 17.10.2003
(51) Int. Cl.: H02M 1/088, H02M 5/293, H02M 5/257, H05B 39/08, H03K 17/567

(54) **Circuit de commande de deux interrupteurs unidirectionnels en courant**

(30) Priorité: 31.10.2002 FR 0213685
(71) Demandeur: STMicroelectronics S.A., 92120 Montrouge (FR)
(72) Inventeur: Peron, Benoit, 37000 Tours (FR)
(74) Mandataire: de Beaumont, Michel

(57) **Abrégé**

L'invention concerne un circuit de commande de deux interrupteurs (K1, K2) montés en anti-parallèle, comprenant en série deux étages (10, 20) de commande identiques respectivement dédiés à chaque interrupteur et entre lesquels est intercalée une impédance (30, 60) commune fixant un angle de phase de fermeture des interrupteurs, chaque étage comportant : une source de courant commandable (14, 24) de fourniture d'un courant à une électrode de commande de l'interrupteur (K1, K2) concernée ; un condensateur (C11, C21) de stockage d'une tension d'alimentation d'au moins la source de courant ; un élément (15, 25) d'activation-désactivation de la source de courant en fonction de la tension aux bornes du condensateur de l'étage ; et un montage (18, 28) de déchargement du condensateur.

## Description

La présente invention concerne la commande de charges alimentées par une tension alternative et, plus particulièrement, le domaine des gradateurs de puissance d'une charge résistive ou inductive.

L'invention concerne plus particulièrement la réalisation d'un gradateur de puissance à partir d'interrupteurs bidirectionnels en tension et unidirectionnels en courant qui sont montés en anti-parallèle. Un problème récurrent concerne alors l'alimentation des circuits de commande respectifs des deux interrupteurs.

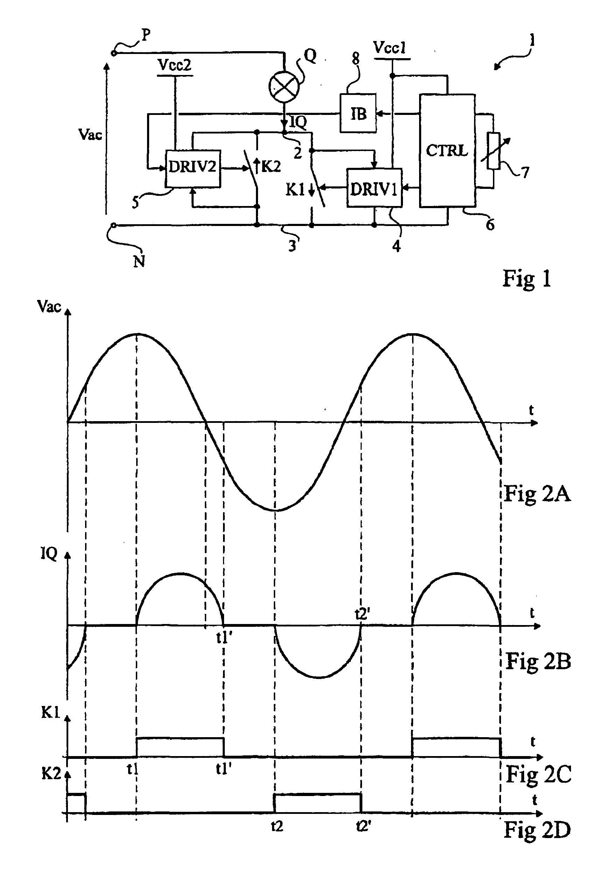

La figure 1 représente, de façon très schématique et sous forme de blocs, un exemple classique de circuit 1 de commande d'une charge Q alimentée par une tension alternative Vac. Deux interrupteurs K1 et K2 sont montés en anti-parallèle entre deux bornes 2 et 3 de puissance du gradateur, connecté en série avec la charge Q entre deux bornes P et N d'application de la tension alternative Vac. Chaque interrupteur K1, K2 a sa borne de commande reliée en sortie d'un circuit 4 (DRIV1), respectivement 5 (DRIV2), générant un signal de commande approprié à partir de consignes de commande reçues d'un circuit de commande commun (CTRL) 6. Le circuit 6 reçoit une consigne de puissance à destination de la charge, par exemple, au moyen d'un potentiomètre 7 ajustant une tension de consigne exploitée par le circuit 6.

Les figures 2A à 2D illustrent le fonctionnement du gradateur de puissance de la figure 1 dont le principe est une commande par angle de phase. Les figures 2A à 2D représentent respectivement des exemples d'allures de la tension Vac, du courant I_{Q} dans la charge Q, et des périodes de fermeture des interrupteurs K1 et K2.

On suppose que la charge Q est une charge inductive, de sorte que son courant est déphasé par rapport à la tension alternative.

La commande par angle de phase consiste à contrôler l'instant de mise en conduction d'un des interrupteurs K1 ou K2 selon l'alternance considérée, à partir du début de l'alternance d'alimentation alternative. En fait, à chaque alternance, on commande l'instant t1, respectivement t2, de fermeture de l'interrupteur K1 ou K2 qui entraîne l'apparition d'un courant dans la charge. L'ouverture de l'interrupteur qui conduit (instant t1', t2', respectivement) est contrôlée par une détection de la disparition du courant I_{Q} dans la charge, ce qui reproduit un fonctionnement de type triac. Comme on suppose une charge inductive, l'instant t1' respectivement t2' d'ouverture des interrupteurs et de disparition du courant dans la charge est décalé par rapport aux instants de passage par zéro de la tension alternative Vac.

Les contraintes que doit respecter un circuit de commande tel qu'illustré par la figure 1 sont de fournir les potentiels de référence aux électrodes de commande des interrupteurs semiconducteurs, de transférer l'information du circuit de commande 6 au circuit (ici 5) ne possédant pas la même référence de tension, et de détecter le passage par zéro du courant dans l'interrupteur conducteur.

Dans les circuits classiques de ce type, le respect de ces contraintes impose le recours à deux alimentations externes indépendantes pour fournir les tensions Vcc1 et Vcc2, donc généralement un transformateur. De plus, le transfert de l'information pour l'étage (par exemple 5) ne possédant pas la même référence de tension que le circuit de commande 6 requiert une barrière d'isolement 8 (IB) de type optocoupleur, transformateur d'impulsions ou décaleur de niveau.

En outre, la détection du zéro de tension requiert, pour permettre une ouverture aux zéro de courant dans la charge et éviter ainsi des surtensions néfastes à l'ouverture, que chaque circuit 4, 5 ait une borne d'entrée reliée à une borne de puissance du gradateur (respectivement, la borne 2 pour l'interrupteur K1 et la borne 3 pour l'interrupteur K2). En pratique, cela conduit généralement à prévoir une résistance (non représentée) en série avec chacun des interrupteurs pour en mesurer la tension. Une telle résistance engendre des pertes non souhaitables lorsque l'interrupteur est à l'état passant.

La présente invention vise à proposer un circuit de commande pour deux interrupteurs unidirectionnels en courant montés en anti-parallèle qui pallie les inconvénients des circuits classiques.

L'invention vise plus particulièrement à proposer un circuit de commande qui ne nécessite pas la génération de tensions d'alimentation externes indépendantes.

L'invention vise également à proposer une solution qui ne requiert pas de barrière d'isolement pour transférer une consigne de commande.

L'invention vise en outre à éviter la présence d'un shunt de courant (résistance, ou sonde à effet hall) en série avec chaque interrupteur pour détecter le zéro de courant dans la charge.

L'invention vise également à proposer un circuit de commande réalisable sous forme de circuit intégré, et compatible avec la réalisation d'un interrupteur bidirectionnel sous forme de dipôle, comprenant deux interrupteurs unidirectionnels en courant et de leur circuit de commande.

Pour atteindre ces objets et d'autres, la présente invention prévoit un circuit de commande de deux interrupteurs bidirectionnels en tension et unidirectionnels en courant, montés en anti-parallèle, comportant en série entre deux bornes du montage en anti-parallèle, deux étages de commande identiques respectivement dédiés à chaque interrupteur et entre lesquels est intercalée une impédance commune fixant un angle de phase de fermeture des interrupteurs, chaque étage comportant :
une source de courant commandable de fourniture d'un courant à une électrode de commande de l'interrupteur concerné ;
un condensateur de stockage d'une tension d'alimentation d'au moins la source de courant ;
un élément d'activation-désactivation de la source de courant en fonction de la tension aux bornes du condensateur de l'étage ; et
un montage de déchargement du condensateur pendant le fonctionnement de l'autre étage.

Selon un mode de réalisation de la présente invention, ladite source de courant est dimensionnée pour contrôler le di/dt à la fermeture de l'interrupteur concerné.

Selon un mode de réalisation de la présente invention, ledit montage de déchargement est activé dès l'annulation du courant dans l'interrupteur concerné.

Selon un mode de réalisation de la présente invention, le condensateur de chaque étage est en série avec une première diode, entre l'impédance et la borne de l'étage qui est confondue avec la borne du montage en anti-parallèle.

Selon un mode de réalisation de la présente invention, une deuxième diode de chaque étage relie ladite impédance à ladite borne de l'étage confondue avec la borne du montage en anti-parallèle.

Selon un mode de réalisation de la présente invention, une troisième diode relie l'électrode de commande de l'interrupteur de chaque étage à l'électrode dudit condensateur, de telle sorte que ledit montage de déchargement décharge également l'électrode de commande de l'interrupteur de l'étage.

Selon un mode de réalisation de la présente invention, le condensateur respectif de chaque étage fournit l'alimentation nécessaire à tous les constituants de l'étage.

Selon un mode de réalisation de la présente invention, ledit élément d'activation-désactivation active ladite source de courant à laquelle il est associé lorsque la tension aux bornes du condensateur de l'étage devient supérieure à un premier seuil, lui-même supérieur à la tension seuil de l'interrupteur concerné.

Selon un mode de réalisation de la présente invention, ledit comparateur désactive ladite source de courant à laquelle il est associé lorsque la tension aux bornes du condensateur de l'étage devient supérieure à un deuxième seuil, lui-même de préférence inférieur à ladite tension seuil de l'interrupteur concerné.

Selon un mode de réalisation de la présente invention, chaque montage de déchargement comporte un premier transistor en parallèle sur le condensateur de l'étage, l'électrode de commande du premier transistor étant reliée, par l'intermédiaire d'un deuxième transistor, à ladite impédance.

Selon un mode de réalisation de la présente invention, ledit élément d'activation-désactivation de chaque étage est constitué d'un comparateur recevant sur une première entrée la tension aux bornes du condensateur de l'étage et sur une deuxième entrée une tension de référence, ledit comparateur étant alimenté par la tension aux bornes du condensateur de l'étage concerné.

Selon un mode de réalisation de la présente invention, ladite impédance est constituée d'un potentiomètre.

Selon un mode de réalisation de la présente invention, ladite impédance est constituée d'une première résistance en parallèle avec une deuxième résistance commutable, ladite première résistance étant de valeur nettement supérieure à la seconde.

L'invention prévoit également un gradateur de puissance d'une charge.

L'invention prévoit également un circuit de commande d'un moteur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente un exemple classique de circuit de commande de deux interrupteurs unidirectionnels montés en anti-parallèle ;
les figures 2A à 2D illustrent, sous forme de chronogrammes, le fonctionnement du circuit de la figure 1 ;
la figure 3 représente un mode de réalisation d'un circuit de commande selon la présente invention ;
les figures 4A à 4J illustrent, sous forme de chronogrammes, le fonctionnement du circuit de la figure 3 ;
les figures 5A à 5D représentent des exemples d'interrupteurs bidirectionnels en tension et unidirectionnels en courant, commandables par un circuit tel que celui illustré par la figure 3 ;
la figure 6 représente une variante de réalisation de l'élément de fixation de la consigne de commande en puissance du circuit de la figure 3 ; et
les figures 7A à 7J illustrent le fonctionnement d'un circuit de commande selon l'invention sur une charge inductive.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la charge commandable par le circuit de l'invention n'a pas été détaillée, celle-ci s'appliquant quelle que soit la charge résistive et/ou inductive à commander par une tension alternative d'alimentation et dont on souhaite moduler la puissance de fonctionnement en fonction d'une consigne.

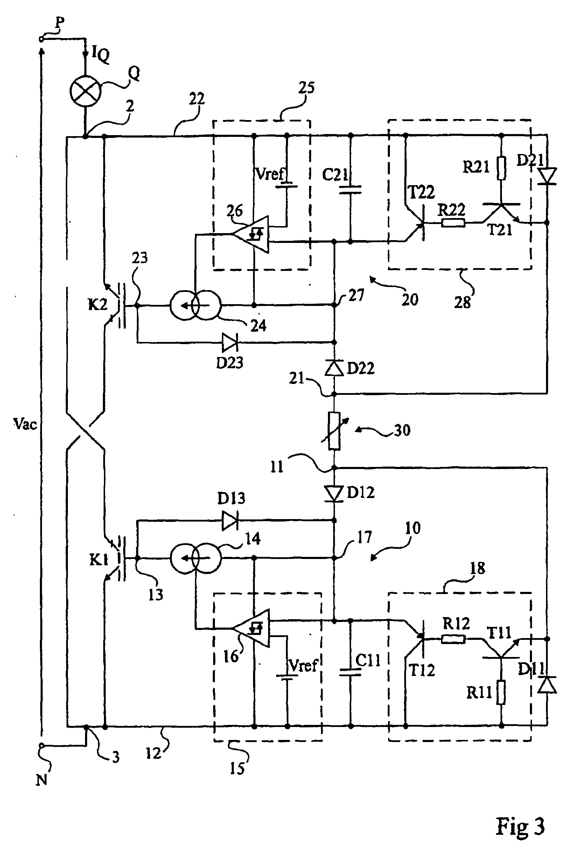

La figure 3 représente un mode de réalisation d'un circuit de commande de deux interrupteurs selon l'invention.

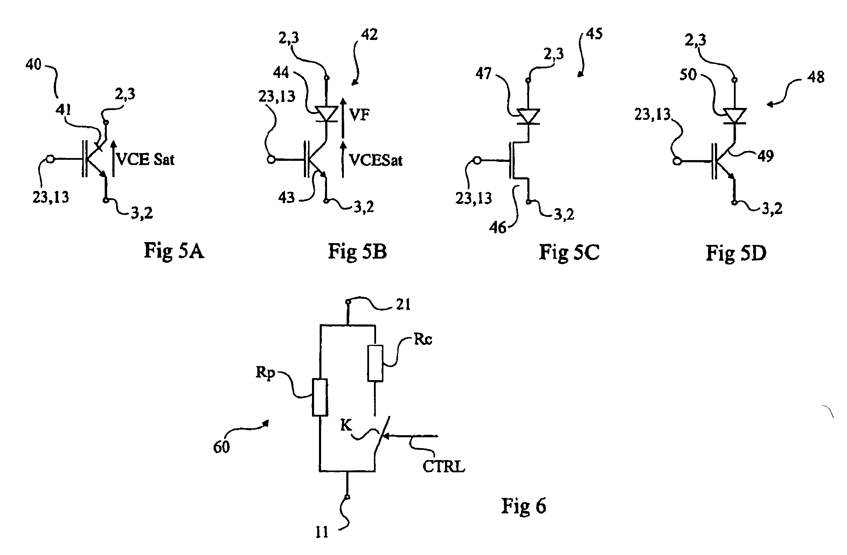

Comme précédemment, deux interrupteurs K1 et K2 unidirectionnels en courant sont connectés en anti-parallèle entre deux bornes 2 et 3 définissant un interrupteur bidirectionnel en tension et en courant, monté en série avec une charge Q entre deux bornes P et N d'application d'une tension alternative Vac. Dans l'exemple de la figure 3, on suppose que les interrupteurs K1 et K2 sont des composants semiconducteurs de type MBS, également appelés RGIGBT. Comme cela sera détaillé en relation avec la figure 5A, de tels interrupteurs reprennent le fonctionnement d'un transistor IGBT en intégrant une diode de protection, ce qui les rend bidirectionnels en tension. Cette diode est symbolisée par un trait sur le collecteur de l'interrupteur.

Selon l'invention, chaque interrupteur K1, K2 est associé à un étage de commande 10, 20 qui lui est dédié. Les étages 10 et 20 sont identiques et sont reliés l'un à l'autre par une impédance commune 30 fixant l'angle de phase de fermeture des interrupteurs. En figure 3, l'impédance commune est constituée d'un potentiomètre 30 dont les deux bornes sont respectivement reliées aux étages 10 et 20. Chaque étage 10, 20 a une structure tripolaire, c'est-à-dire qu'il comprend deux bornes 11 et 12, respectivement 21 et 22, connectées entre l'impédance commune 30 et l'émetteur du transistor MBS K1, respectivement K2, et une borne de sortie 13, respectivement 23, de commande de l'interrupteur K1, respectivement K2. On voit déjà apparaître une différence par rapport au circuit de commande classique de la figure 1 pour lequel les étages affectés aux interrupteurs respectifs requièrent cinq bornes.

La structure d'un étage de commande selon l'invention sera décrite par la suite en relation avec l'étage 10 de commande de l'interrupteur K1. L'étage 20 de commande de l'interrupteur K2 présente exactement la même structure et ses constituants sont référencés en figure 3 par des références commençant par le chiffre 2 et non par le chiffre 1.

L'étage 10 comporte une source de courant 14 commandable dont la sortie est reliée à la borne 13 de commande de l'interrupteur K1 et qui est destinée à commander sa fermeture. Par exemple, la source de courant 14 est une source de courant constant commandée par un élément 15 d'activation-désactivation. Selon l'invention, l'élément 15 active la source de courant 14 en fonction de la tension aux bornes d'un condensateur C11 fonctionnellement en série avec le potentiomètre 30 entre les bornes 2 et 3 de l'interrupteur, l'impédance du potentiomètre 30 conditionnant donc l'angle de phase de fermeture de l'interrupteur K1.

Dans l'exemple de la figure 3, l'élément d'activation-désactivation de la source de courant est constitué d'un comparateur 16 à hystérésis dont une première entrée est reliée à l'électrode du condensateur C11 opposée à la borne 3 et dont une deuxième entrée reçoit une tension de référence Vref fournie, par exemple, par une diode Zener ou un circuit de génération d'une référence de tension de type Bandgap.

Selon l'invention, le condensateur C11 a également le rôle d'alimenter l'étage 10 pendant les alternances (par exemple, positives) affectées à cet étage 10. Ainsi, ce condensateur C11 fournit la tension d'alimentation de la source de courant 14 lui permettant d'activer l'interrupteur K1 ainsi que la tension d'alimentation de l'élément d'activation-désactivation (plus particulièrement du comparateur 16) dont les bornes d'alimentation respectives sont connectées aux bornes 17 et 12 du condensateur C11.

Pour affecter l'étage 10 à un seul type d'alternances, ici les alternances positives, une diode D12 relie la borne 11 de l'impédance 30 à l'électrode 17 du condensateur. Cette diode D12 dont l'anode est connectée à la borne 11 n'est polarisée en direct que pendant les alternances positives. Pour permettre la circulation du courant malgré la présence de la diode (D22) associée à l'étage 20, une diode D21 de cet étage 20 court-circuite ses bornes 21 et 22 pendant les alternances positives, l'anode de la diode D21 étant connectée à la borne 22. Côté étage 10, une diode D11 est connectée entre les bornes 11 et 12, son anode étant connectée à la borne 12.

Selon l'invention, l'étage 10 comporte également un montage 18 de déchargement du condensateur C11 pendant l'alternance où cet étage n'est pas conducteur, afin de réinitialiser l'étage en préparation de l'alternance positive suivante. Pendant cette décharge, il est également nécessaire de décharger la grille de l'interrupteur K1 si celui-ci est du type à grille isolée. Pour cela, on relie alors la borne 13 à l'électrode 17 du condensateur C11 par une diode D13 dont l'anode est connectée à la borne 13. Ainsi, on déchargera la grille de l'interrupteur K1 en même temps que le condensateur C11.

Dans l'exemple de la figure 3, le montage 18 est constitué d'un premier transistor bipolaire de type PNP T12 connecté entre les électrodes 17 et 12 du condensateur C11, son émetteur étant connecté à l'électrode 17. La base du transistor T12 est connectée, de préférence par l'intermédiaire d'une résistance de polarisation R12, au collecteur d'un transistor bipolaire de type NPN T11 dont l'émetteur est connecté à la borne 11, c'est-à-dire à l'extérieur de l'étage 10 pour permettre une conduction pendant les alternances de signe opposé. La base du transistor T11 est connectée, de préférence par l'intermédiaire d'une résistance de polarisation R11, à la borne 12 de l'étage 10.

On voit déjà que le circuit de commande de l'invention, dans sa version telle qu'illustrée par la figure 3 où l'élément de commande est un potentiomètre, se présente sous la forme d'un dipôle complètement autonome.

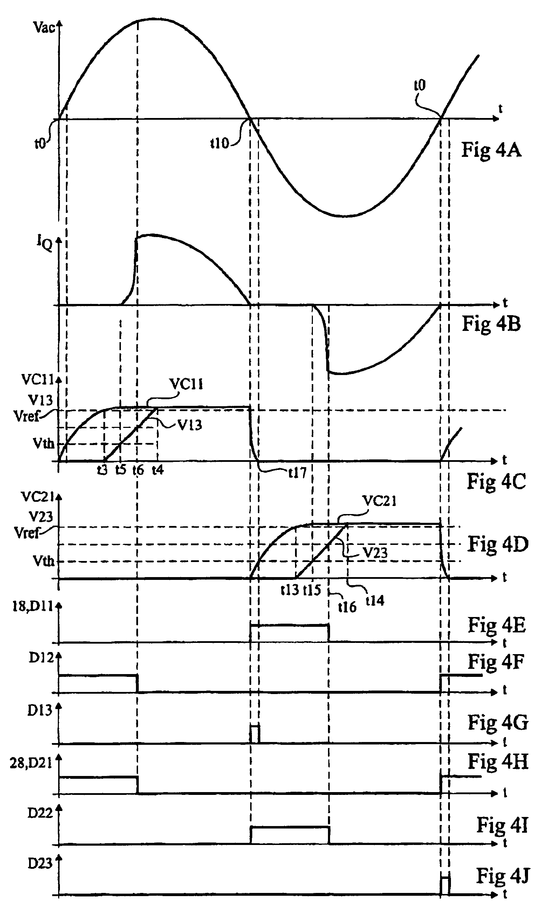

Les figures 4A à 4J illustrent, par des chronogrammes, le fonctionnement du circuit de la figure 3. Ces chronogrammes représentent respectivement des exemples d'allures des signaux Vac, I_{Q}, VC11 et V13 représentant respectivement la tension aux bornes du condensateur C11 et la tension de polarisation de la grille de l'interrupteur K1, VC21 et V23 représentant respectivement la tension aux bornes du condensateur C21 et la tension de grille de l'interrupteur K2, les périodes de conduction du circuit 18 et de la diode D11, les périodes de conduction de la diode D12, les périodes de conduction de la diode D13, les périodes de conduction du circuit 28 et de la diode D21, les périodes de conduction de la diode D22, et les périodes de conduction de la diode D23.

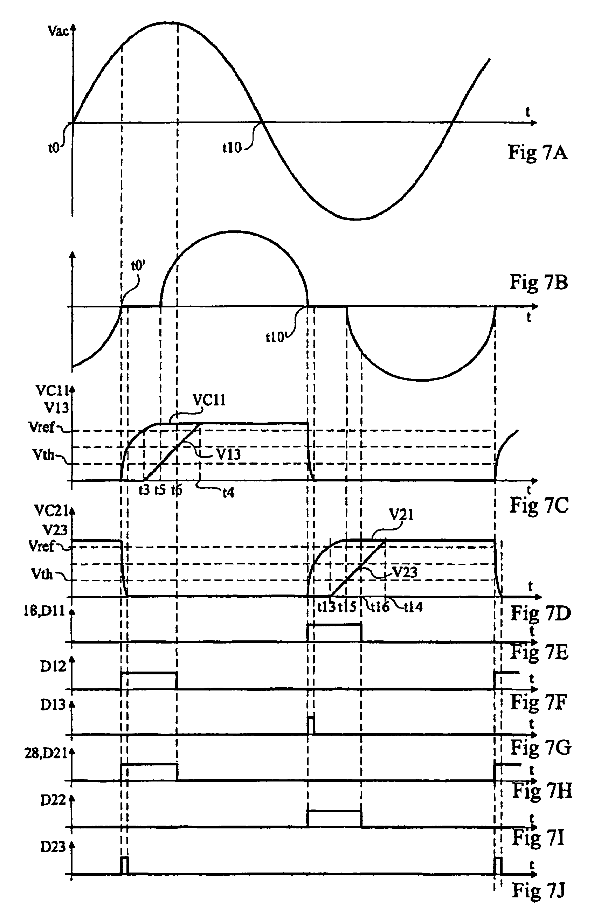

Les figures 4A à 4J illustrent le fonctionnement du circuit pour commander une charge Q purement résistive. Un autre exemple appliqué à une charge inductive (ou résistive et inductive) sera décrit plus loin en relation avec les figures 7A à 7J.

Initialement, les condensateurs C11 et C12 sont déchargés et toutes les diodes et transistors sont bloqués. On suppose qu'à un instant t0, on applique la tension alternative Vac aux bornes du système et on suppose, pour simplifier la description, que cet instant correspond au début d'une alternance positive. De la description qui suit, il ressortira toutefois que l'instant de mise sous tension n'a pas d'incidence néfaste sur le fonctionnement. Pour simplifier, on ne tiendra pas compte des chutes de tension en direct des différentes diodes (généralement de l'ordre de 0,6 volts) lorsqu'elles n'ont pas d'influence sur le fonctionnement du circuit.

Dès le début de l'alternance positive (à partir de l'instant t0), les diodes D21 et D12 se trouvent polarisées en direct (figure 4F et figure 4H), tandis que les diodes D22 et D11 sont bloquées (figure 4E et figure 4I) . Par ailleurs, comme la diode D21 est passante, l'étage 28 conduit également. Pour l'instant, on se contente de noter que le fait que cet étage conduit force un blocage de l'interrupteur K2 et une décharge du condensateur C22. Le fonctionnement du montage de déchargement sera détaillé plus loin en relation avec le fonctionnement de l'étage 10. De même, les transistors T11 et T12 du montage 18 sont tous deux bloqués dans la mesure où la diode D11 est bloquée. Il en découle que la diode D13 est bloquée dans la mesure où on suppose un potentiel initialement bas (potentiel de la borne 12) pour la grille de l'interrupteur K1.

Un courant de charge du condensateur C11 circule donc depuis la borne 2 vers la borne 3 à travers la diode 21, le potentiomètre 30 et la diode D12. La rapidité avec laquelle se charge le condensateur C11 (figure 4C) dépend de la résistance de l'élément 30. Le condensateur C11 et la plage de variation de la résistance 30 sont dimensionnés pour que la tension aux bornes du condensateur C11 soit suffisante pour alimenter le comparateur 16 et la source de courant 14. La constitution de la source 14 pourra être quelconque pourvu d'être commandable. Par exemple, il pourra s'agir d'une source de courant réalisée à partir d'un miroir de courant en transistors MOS, alimenté par la tension aux bornes du condensateur C11.

A un instant t3, la tension aux bornes du condensateur C1 atteint la tension de référence Vref du comparateur 16. Il en découle une commutation de ce comparateur, ce qui active la source de courant 14. En supposant un courant constant fourni par la source 14, le potentiel de la grille 13 de l'interrupteur K1 se met à croître à partir de l'instant t3 et sa croissance se poursuit jusqu'à rejoindre, à un instant t4, le potentiel de la borne 17, c'est-à-dire la tension VC11. A partir de l'instant t4, la tension de grille V13 de l'interrupteur K1 suit l'allure de la tension VC11 aux bornes du condensateur C11.

Entre les instants t3 et t4, dès que la tension V13 atteint la tension seuil Vth de l'interrupteur K1 (instant t5), celui-ci devient conducteur et un courant commence à circuler dans la charge Q par l'intermédiaire de l'interrupteur K1 (figure 4B). La croissance du courant I_{Q} dans la charge s'effectue sans pic grâce à la source de courant 14 qui contrôle di/dt à la fermeture de l'interrupteur K1. On suppose qu'à un instant t6, le courant I_{Q} dans la charge a rejoint l'allure de la tension alternative Vac, l'interrupteur K1 ayant atteint sa zone de fonctionnement saturée.

Selon l'invention, pour que cette condition soit respectée, la tension Vref (plus précisément, le niveau de commutation du comparateur 16 dans le sens croissant de la tension du condensateur C11) est choisie pour être nettement supérieure à la tension seuil Vth de l'interrupteur K1.

A l'instant t6 où l'interrupteur K1 est pleinement passant, les bornes 2 et 3 du circuit de commande se trouvent court-circuitées, ce qui entraîne le blocage des diodes D21 et D12 et, par voie de conséquence, de l'étage 28.

L'étage 10 est alors isolé de l'alimentation alternative et de la charge. Par conséquent, le condensateur C11 ne se décharge pas. Dans l'exemple de la figure 3, l'interrupteur K1 est un MBS, c'est-à-dire un composant à grille isolée. La décharge du condensateur C11 liée à la commande de grille de cet interrupteur est donc négligeable.

A l'instant t10 où l'alternance positive de la tension Vac s'annule, il ne se passe rien. En effet, bien que l'on ait négligé les chutes de tension dans les différentes diodes, il faut attendre le début de l'alternance négative pour que les diodes D11 et D22 deviennent conductrices et qu'un courant circule alors dans le circuit de commande et dans le potentiomètre 30 pour charger le condensateur C22 pendant cette alternance négative. Côté étage 20, on reproduit pendant l'alternance négative le fonctionnement exposé ci-dessus en relation avec l'alternance positive.

Côté étage 10, la conduction de la diode D11 provoque l'activation du montage 18 de déchargement du condensateur C1. En fait, la conduction de la diode D11 rend le transistor T11 conducteur et la différence de potentiel existante aux bornes du condensateur C11 permet la mise en conduction du transistor T12 qui provoque alors la décharge du condensateur C11. De plus, comme la grille de l'interrupteur K1 est initialement au potentiel V13, identique à la tension aux bornes du condensateur C11, la diode D13 se trouve polarisée en direct, ce qui permet la décharge de la grille de l'interrupteur 13 pour préparer celui-ci pour l'alternance suivante.

En fait, le condensateur C11 se décharge peu après le début de l'alternance négative, c'est-à-dire dès que la diode D11 conduit. En d'autres termes, dès que la tension entre les bornes 2 et 3 du circuit de commande devient supérieur à -2*Vf, où Vf représente la chute de tension d'une diode en direct, ici - (Vf_{D11}+Vf_{D22}) où Vf_{D11} et Vf_{D22} représentent les chutes de tension en direct respectives des diodes D11 et D22. Lors de l'ouverture de l'interrupteur K1, il ne se produit pas de pic de courant dans la mesure où l'ouverture intervient alors que la tension aux bornes du commutateur est négative.

Aux figures 4, on a considéré que le condensateur C11 se trouvait intégralement déchargé à un instant t17. A partir de cet instant, la diode D13 se bloque, la grille de l'interrupteur K11 étant déchargée. Lors de la décharge du condensateur C11, le comparateur 16 commute pour éteindre la source de courant 14, avant que ce condensateur C11 soit intégralement déchargé.

Le seuil de commutation bas (tension VC11 décroissante) du comparateur 16 est, de préférence, inférieur à la tension seuil Vth de l'interrupteur K1 pour des raisons de stabilité à l'ouverture de la source de courant. Par conséquent, l'hystérésis du comparateur 16 est choisie pour que le seuil Vth soit compris entre le seuil Vref de commutation dans le sens croissant et le seuil de commutation dans le sens décroissant.

En fin d'alternance négative, on assiste de nouveau à une conduction de l'étage de commande 10. Celui-ci redémarre comme dans l'état initial décrit précédemment dans la mesure où tous ses composants se sont trouvés déchargés par la décharge du condensateur C11. La seule différence est que la diode 23 devient conductrice au début de la deuxième alternance positive alors qu'elle ne l'était pas lors de la première alternance car on avait considéré un état initial non alimenté du circuit.

Une variation de la résistance 30 a pour effet de modifier l'aspect de charge des condensateurs C11 et C22 selon les alternances et, par voie de conséquence, les instants t3 et t13 de début de conduction des commutateurs K1 et K2 à chaque alternance.

Un avantage de la présente invention est que le circuit de commande ne nécessite aucun circuit d'alimentation externe et notamment aucun transformateur.

Un autre avantage de la présente invention est que la détection du zéro de courant effectuée par lecture de la tension inverse évite l'apparition de surtensions lors de l'ouverture des commutateurs sur charge inductive.

Un autre avantage de l'invention est que le di/dt à la fermeture des commutateurs est contrôlé par la source de courant 14.

Un autre avantage de l'invention est qu'elle ne requiert aucune barrière d'isolement pour assurer la commande de l'un ou l'autre des étages.

D'autres avantages de l'invention résident dans la simplicité du circuit de commande et dans la symétrie de la commande réalisée quel que soit le signe de l'alternance.

Un autre avantage de l'invention est que le circuit de commande proposé est entièrement intégrable (à l'exception néanmoins du potentiomètre de commande). En effet, comme il ressort du fonctionnement décrit ci-dessus, aucune des diodes du circuit de commande (notamment les diodes D11, D12, D21 et D22) n'a besoin de tenir une tension élevée. En effet, les seules périodes (instants t6 à t10 et t16 à t0) pendant lesquelles le courant circulant dans le circuit de commande n'est pas absorbé par le potentiomètre 30, sont les périodes où l'un des interrupteurs K1 ou K2 est pleinement conducteur (saturé), d'où il résulte que les bornes 2 et 3 sont court-circuitées.

Un autre avantage de la présente invention est que le gradateur de puissance ainsi constitué ne requiert ni inductance, ni condensateur de filtrage, ni alimentation externe. L'invention est donc parfaitement compatible avec la réalisation d'un gradateur sous la forme d'un dipôle.

Les figures 5A à 5D illustrent des exemples de commutateurs K1 ou K2 susceptibles d'être utilisés dans un circuit de commande selon l'invention. La figure 5A représente le schéma d'un transistor de type MBS 40 tel que représenté en relation avec la figure 3. Un tel composant présente l'avantage d'être unidirectionnel en courant tout en étant bidirectionnel en tension, c'est-à-dire tenant la tension inverse grâce à une diode intégrée, symbolisée par un trait 41 en figure 5A. Il en découle que la chute de tension à l'état passant est limitée à la tension collecteur-émetteur de saturation VCEsat du composant.

La figure 5B illustre un deuxième exemple de commutateur 42 constitué d'un transistor IGBT 43 en série avec une diode 44. Le schéma de la figure 5B constitue un équivalent du transistor MBS 40 de la figure 5A mais dans lequel la chute de tension à l'état passant correspond à la somme de la tension VCEsat du transistor IGBT 43 et de la tension V_{F} de la diode 44 en direct.

La figure 5C représente un troisième exemple d'interrupteur 45, constitué ici d'un transistor MOS 46 en série avec une diode 47.

La figure 5D illustre un quatrième exemple de commutateur 48 constitué d'un transistor bipolaire de type NPN 49 en série avec une diode 50.

Toute structure de commutateur unidirectionnel en courant et bidirectionnel en tension (même si le caractère bidirectionnel en tension est apporté par une diode distincte introduisant une chute de tension supplémentaire) peut être utilisée. La seule précaution éventuelle est, dans le cas d'un transistor bipolaire (figure 5D) ou plus généralement d'un interrupteur à commande en courant, de prévoir un condensateur C11 de capacité suffisante pour assurer la fourniture du courant de base au transistor 49 pendant toute sa période de conduction, tout en maintenant l'alimentation du comparateur 16 et de la source de courant 14. Dans le cas où il n'est pas indispensable de décharger l'électrode de commande de l'interrupteur, la diode D13 (ou D23) peut être omise.

La figure 6 représente un deuxième mode de réalisation d'un élément 60 constituant une impédance commune entre les étages 10 et 20 de la figure 3. Ce mode de réalisation est destiné à permettre une commande du gradateur de puissance par un signal CTRL externe au gradateur de puissance proprement dit.

Selon ce mode de réalisation, l'impédance 60 comporte, en parallèle entre ses bornes 21 et 11, une résistance Rp de protection et une association en série d'une résistance Rc et d'un commutateur K commandé par le signal externe CTRL. Le rôle de la résistance Rc est de limiter le courant dans les diodes D12, D21 et D22, D11 respectivement, lorsque l'interrupteur K est fermé. Cela permet d'autoriser une fermeture de l'interrupteur K à n'importe quel instant par rapport à la tension d'alimentation Vac. Le rôle de la résistance Rp est de garantir une ouverture automatique au zéro de courant même si l'interrupteur K s'est trouvé ouvert entre temps sous l'effet d'une disparition du signal CTRL. On veillera à choisir une résistance Rp nettement plus importante que la résistance Rc afin de permettre une circulation du courant dans la branche de résistance Rc lorsque l'interrupteur est fermé. De plus, la résistance Rp devra être d'une valeur suffisamment grande pour que la charge des condensateurs C11 et C21 ne puisse pas atteindre le niveau Vref en une demi-période d'alimentation alternative lorsque l'interrupteur K est ouvert.

Les figures 7A à 7J illustrent, par des chronogrammes représentant les mêmes signaux que les figures 4A à 4J, le fonctionnement d'un circuit de commande selon l'invention, connecté à une charge Q au moins partiellement inductive. La différence principale par rapport aux chronogrammes des figures 4A à 4J est que l'allure du courant I_{Q} dans la charge a une croissance dont le di/dt est limité naturellement par l'inductance de la charge.

Une autre différence est qu'en raison du déphasage apporté par l'inductance de la charge sur les instants (t0', t10', figure 7B) d'annulation du courant dans celle-ci par rapport aux instants de passage par zéro (t0, t10, figure 7A) de la tension Vac, la charge du condensateur C11 ou C21 s'effectue plus rapidement. Il en découle que l'instant t3 de début de fonctionnement de la source de courant 14 est plus près de l'instant t0' qu'il ne l'est de l'instant t0 dans une charge purement résistive.

Pour le reste, le fonctionnement du circuit de commande se déduit de l'exposé effectué précédemment en relation avec une charge résistive.

On notera que même sur une charge inductive, l'invention ne nécessite pas de shunt en série avec la charge pour détecter le passage par zéro du courant dans la charge. Selon l'invention, on utilise le déphasage lié à la charge inductive pour garantir une ouverture des commutateurs à un moment où la tension à leurs bornes est négative. Cela induit une détection naturelle du zéro de courant. Un avantage est alors que l'on évite les sur-tensions à l'ouverture des commutateurs de type thyristor. Un autre avantage est que cela réduit les pertes liées à la résistance de shunt, en série avec le commutateur, dans les circuits classiques.

L'impédance de commande de l'invention intervient sur une charge inductive comme pour une charge résistive afin de contrôler la charge du condensateur C11 ou C21 selon l'alternance, donc l'intervalle entre les instants t'0 et t3 et t'10 et t13 respectivement. Comme une fois le condensateur chargé et le comparateur 16 déclenché, la commande de l'interrupteur est fixée par la source de courant 14 dont le fonctionnement est indépendant de l'impédance 30, la fixation de l'instant t3 revient bien à fixer l'instant t5 de début de conduction de la charge.

Bien entendu, la présente invention est susceptible de diverses variantes et modifications qui apparaîtront à l'homme de l'art. En particulier, la réalisation pratique des sources de courant et des comparateurs est à la portée de l'homme du métier à partir des indications fonctionnelles données ci-dessus. On rappellera toutefois que ces constituants ne nécessitent pas d'alimentation distincte de celle apportée par les condensateurs C1 et C21 prévus par le circuit de l'invention.

De plus, les dimensionnements des condensateurs et résistances, ainsi que des composants semiconducteurs est à la portée de l'homme du métier en fonction de l'application et du fonctionnement souhaité.

En outre, on notera que l'invention peut réaliser un gradateur de puissance non seulement pour des circuits de type lampe, mais également pour assurer la commande de moteurs grâce à son fonctionnement performant sur charge inductive.

Enfin, bien que selon un mode de réalisation préféré, l'invention prévoit un fonctionnement symétrique avec des tensions Vref identiques pour le comparateur 16 et pour le comparateur 26, elle n'exclut pas une dissymétrie selon l'alternance positive ou négative, simplement en modifiant les tensions Vref utilisées.

## Revendications

1. Circuit de commande de deux interrupteurs (K1, K2) bidirectionnels en tension et unidirectionnels en courant montés en anti-parallèle, **caractérisé en ce qu'**il comporte, en série entre deux bornes (2, 3) du montage en anti-parallèle, deux étages (10, 20) de commande identiques respectivement dédiés à chaque interrupteur et entre lesquels est intercalée une impédance (30, 60) commune fixant un angle de phase de fermeture des interrupteurs, chaque étage comportant :
une source de courant commandable (14, 24) de fourniture d'un courant à une électrode de commande de l'interrupteur (K1, K2) concernée ;
un condensateur (C11, C21) de stockage d'une tension d'alimentation d'au moins la source de courant ;
un élément (15, 25) d'activation-désactivation de la source de courant en fonction de la tension aux bornes du condensateur de l'étage ; et
un montage (18, 28) de déchargement du condensateur pendant le fonctionnement de l'autre étage.

2. Circuit selon la revendication 1, **caractérisé en ce que** ladite source de courant (14, 24) est dimensionnée pour contrôler le di/dt à la fermeture de l'interrupteur concerné (K1, K2) .

3. Circuit selon la revendication 1 ou 2, **caractérisé en ce que** ledit montage de déchargement (18, 28) est activé dès l'annulation du courant dans l'interrupteur concerné (K1, K2).

4. Circuit selon l'une quelconque des revendications 1 à 3, **caractérisé en ce que** le condensateur (C11, C21) de chaque étage (10, 20) est en série avec une première diode (D12, D22), entre l'impédance (30, 60) et la borne (12, 22) de l'étage qui est confondue avec la borne (3, 2) du montage en anti-parallèle.

5. Circuit selon la revendication 4, **caractérisé en ce qu'**une deuxième diode (D11, D21) de chaque étage (10, 20) relie ladite impédance (30) à ladite borne (12, 22) de l'étage confondue avec la borne (3, 2) du montage en anti-parallèle.

6. Circuit selon la revendication 5, **caractérisé en ce qu'**une troisième diode (D13, D23) relie l'électrode de commande de l'interrupteur de chaque étage (10, 20) à l'électrode dudit condensateur (C11, C21), de telle sorte que ledit montage de déchargement (18, 28) décharge également l'électrode de commande de l'interrupteur (K1, K2) de l'étage.

7. Circuit selon l'une quelconque des revendications 1 à 6, **caractérisé en ce que** le condensateur respectif (C11, C21) de chaque étage (10, 20) fournit l'alimentation nécessaire à tous les constituants de l'étage.

8. Circuit selon l'une quelconque des revendications 1 à 7, **caractérisé en ce que** ledit élément d'activation-désactivation (15, 25) active ladite source de courant (14, 24) à laquelle il est associé lorsque la tension aux bornes du condensateur (C11, C21) de l'étage (10, 20) devient supérieure à un premier seuil (Vref), lui-même supérieur à la tension seuil (Vth) de l'interrupteur concerné (K1, K2).

9. Circuit selon la revendication 8, **caractérisé en ce que** ledit comparateur désactive ladite source de courant (14, 24) à laquelle il est associé lorsque la tension aux bornes du condensateur (C11, C21) de l'étage (10, 20) devient supérieure à un deuxième seuil, lui-même inférieur à ladite tension seuil (Vth) de l'interrupteur concerné (K1, K2).

10. Circuit selon l'une quelconque des revendications 1 à 9, **caractérisé en ce que** chaque montage de déchargement (18, 28) comporte un premier transistor (T12, T22) en parallèle sur le condensateur (C11, C21) de l'étage, l'électrode de commande du premier transistor étant reliée, par l'intermédiaire d'un deuxième transistor (T11, T12) à ladite impédance (30).

11. Circuit selon l'une quelconque des revendications 1 à 10, **caractérisé en ce que** ledit élément d'activation-désactivation de chaque étage (10, 20) est constitué d'un comparateur (16, 26) recevant sur une première entrée la tension aux bornes du condensateur (C11, C21) de l'étage et sur une deuxième entrée une tension de référence (Vref), ledit comparateur étant alimenté par la tension aux bornes du condensateur de l'étage concerné.

12. Circuit selon l'une quelconque des revendications 1 à 11, **caractérisé en ce que** ladite impédance (30) est constituée d'un potentiomètre.

13. Circuit selon l'une quelconque des revendications 1 à 11, **caractérisé en ce que** ladite impédance (60) est constituée d'une première résistance (Rp) en parallèle avec une deuxième résistance commutable (Rc), ladite première résistance étant de valeur nettement supérieure à la seconde.

14. Gradateur de puissance d'une charge, **caractérisé en ce qu'**il comporte un circuit selon l'une quelconque des revendications 1 à 13.

15. Circuit de commande d'un moteur, **caractérisé en ce qu'**il comporte un circuit selon l'une quelconque des revendications 1 à 12.
